# EUROPEAN PATENT APPLICATION

(11) **EP 4 626 167 A1**
(43) Date of publication of application: **01.10.2025**
(21) Application number: 25164048.8
(22) Date of filing: 17.03.2025
(51) Int. Cl.: H10D 12/00, H10D 12/01, H01L 21/283, H10D 8/00, H10D 64/00, H10D 64/23, H10D 64/62, H10D 84/00

(54) **REVERSE-CONDUCTING IGBT DEVICE WITH LOW EFFICIENCY INJECTION ANODE AND MANUFACTURING PROCESS THEREOF**

(30) Priority: 27.03.2024 IT 202400006895
(71) Applicant: STMicroelectronics International N.V., 1228 Plan-les-Ouates, Geneva (CH)
(72) Inventor: BERTUGLIA, Ignazio, 95127 Catania (IT); CHIACCHIO, Ettore, 95129 Catania (IT)
(74) Representative: Studio Torta S.p.A.

(57) **Abstract**

The reverse-conducting IGBT device is formed in a die (53) having a substrate (2) of a first conductivity type accommodating an IGBT (50) in a first portion (1A) and a diode (52) in a second portion (1B). The IGBT (50) has a body structure (14, 18); a source region (20); a trench-gate region (25); a first contact structure (37, 38), formed on the first main surface and in direct electrical contact with the body structure (14, 18); and an emitter region (47), of the second conductivity type, on the second upper surface (2B) of the substrate. The diode (52) has an anode region (13), of the second conductivity type, facing the first main surface (2A); and a second contact structure (32A, 44A), formed on the first main surface (2A) and in direct electrical contact with the anode region (13). The second contact structure is electrically coupled with the first contact structure (37, 38) and is formed by a barrier layer (32A) of cobalt disilicide extending above the first main surface (2A) of the substrate, in contact with the anode region (13), and by a diode contact plug (44A), of metal, above and in contact with the barrier layer (32A).

## Description

### Technical Field

The present invention relates to a Reverse-Conducting IGBT (RC-IGBT) device with Low Efficiency Injection Anode (LEIA) and to the manufacturing process thereof.

In particular, the invention refers to an RC-IGBT including a vertical-conducting IGBT device and a diode (in particular a Freewheeling Diode, FWD), integrated side by side in a same die.

### Background

As known, in various applications where the IGBT (Insulated-Gate Bipolar Transistor) device is used as a switch on an inductive load, it is connected to a freewheeling diode, connected in antiparallel, to discharge the switching current and prevent potential damage and sudden voltage peaks.

Providing separate dice, one accommodating the IGBT and the other one accommodating the diode, is normally the preferred solution in all cases where a good trade-off between static and dynamic performances is required. However, integrated solutions (referred to as Reverse-Conducting IGBT, RC-IGBT, integrated solutions) may be considered to reduce cost and size. In fact, an RC-IGBT that integrates the diode and the IGBT in a single die offers cost savings and further miniaturization of the packaging.

Furthermore, in soft-switching conditions (i.e. in switching conditions with zero or close-to-zero voltage and/or current) the RC-IGBT may have performances comparable to those of discrete configurations that include an IGBT connected to the external diode. These solutions are increasingly appreciated for induction heating applications.

A different and more complicated situation is instead hard-switching (i.e. switching that occurs with a superimposition of non-zero voltage and current) since, in this case, further optimization of the reverse recovery performances of the diode is necessary. In this case, current IGBT manufacturing technologies do not allow fast diodes to be obtained and diode optimization occurs at the expense of IGBT performances.

However, these solutions are currently limited to situations where non-optimized reverse recovery of the integrated diode may be accepted, essentially to induction cooking devices or to motor control applications with low nominal current and hard-switching regime. In these cases, techniques for controlling the average lifetime of the charge carriers are commonly adopted, in order to reduce the reverse-recovery current Irr (and the reverse-recovery charge Qrr as well as the reverse-recovery time Trr), but these have negative effects on the IGBT. Alternatively, reduced doping of the P+ deep body layer has been proposed, but at the expense of anti-latch robustness, which is negatively affected.

Another possibility is to adopt the LEIA (Low Efficiency Injection Anode Diode, or controlled emitter diode) concept wherein the anode of the diode is formed separately from the body region of the IGBT using a lower doping dose (for example by 10%) than that of the body region.

However, a drawback of this solution is the formation of a rectifying (or Schottky) contact on the low-doped anode, which may be solved by removing the TiTiN barrier region from the diode region and depositing, by sputtering, a metal layer formed by an aluminum and silicon (AlSi or AlSiCu) alloy on the front side. Currently, devices of this type are already available for high-power switching and hard-switching applications.

However, the use of an aluminum/silicon alloy implies the need for a more complicated process flow to keep the wafer defectiveness under control.

US 2020/0287028, DE 10 2021 125993 and CN 112563321 disclose semiconductor devices having barrier metal films.

The aim of the present invention is to provide an RC-IGBT device with low efficiency injection anode which solves the problems of the prior art. In particular, aim of the invention is to provide a reverse-conducting IGBT device avoiding undesired Schottky behaviour and promoting ohmic behaviour with reduced contact resistant an a lightly doped anode.

### Summary

According to the present invention, a reverse-conducting IGBT device with low efficiency injection anode and a manufacturing process thereof are proposed, as defined in the attached claims.

### Brief Description of the Drawings

For a better understanding of the present invention, an embodiment thereof is now described, purely by way of nonlimiting example, with reference to the attached drawings, wherein:
- Figures 1A, 2A, 3A, 4A, 5A, 6A, 7A, 8A and 9A are cross-sectional views of a wafer of semiconductor material wherein an RC-IGBT device is formed during successive manufacturing steps;
- Figures 1B, 2B, 3B, 4B, 5B, 8B and 9B are enlarged details of the RC-IGBT device in manufacturing steps corresponding to those of Figures 1A-9A having the same figure number;
- Figure 1C is a top view of the arrangement of areas of the RC-IGBT device of Figure 1A;
- Figure 10 is a cross-section similar to Figure 9A of a LEIA RC-IGBT device after performing the final steps and dicing, wherein the electrical equivalents are represented; and
- Figure 11 is a schematic representation of a system (an inverter stage) which includes a plurality of RC-IGBT devices according to Figure 10.

### Description of Embodiments

The following description refers to the arrangement shown; consequently, expressions such as "above", "below", "upper", "lower", "right", "left" relate to the attached Figures and are not to be interpreted in a limiting manner.

Hereinafter a reverse-conducting IGBT device with low efficiency injection anode (LEIA RC-IGBT) is described that preferably uses, for the contact metallization of the anode, aluminum-based materials, such as for example an alloy of Al and Cu, pure aluminum or an alloy containing Al and Si, by introducing a dedicated barrier. This barrier allows avoiding interdiffusion of the metal of the metallization as well as obtainment of a correct ohmic contact between metal and the underlying low-doped anode region.

In particular, the following figures refer to a LEIA RC-IGBT device having, in the diode region, a barrier based on cobalt disilicide (CoSi₂). This barrier allows a better ohmic contact with an Al-based metallization, used for the contact, for example an AlCu or Al metallization. In this manner a good trade-off may be obtained between VF (voltage drop on the diode in forward conduction mode) and Err (energy in the reverse recovery transient of the diode) for the LEIA RC-IGBT device without being limited to using only AlSi or AlSiCu, which however may be used, if useful in the process. The LEIA RC-IGBT structure described below, which introduces CoSi₂ into the very low doped anode region, allows the performances of the IGBT and the diode to be maximized at the same time without any process flow constraints, regardless of the type of Al-alloy metallization used.

CoSi₂ reduces the need for enriching the diode contacts, thus allowing the diode part to obtain even better Qrr (charge in the reverse recovery transient of the diode) vs. VF trade-off performances.

The present invention is now described with reference to the figures, which show cross-sectional views of a portion of a wafer 1 during subsequent manufacturing steps. The figures show the wafer 1 in a triaxial Cartesian system of mutually orthogonal axes (first axis X, second axis Y, and third axis Z).

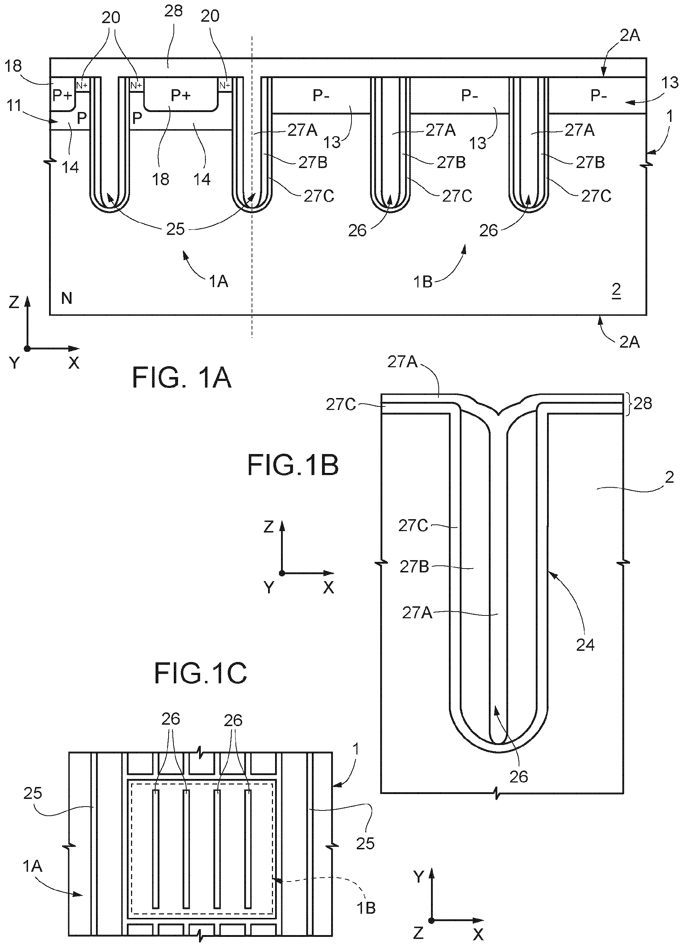

In detail, Figures 1A, 1B and 1C show the wafer 1 after initial processing steps, as described in US patent application US2023103191A1, briefly summarized hereinbelow.

The wafer 1 comprises two sub-portions: a first sub-portion 1A (hereinafter also referred to as IGBT portion 1) and a second sub-portion 1B (hereinafter also referred to as diode portion 2), which are arranged, or extend, adjacent to each other without physical interruption.

The IGBT portion 1A is designed to accommodate (at least in part) an IGBT device, while the diode portion 1B is designed to accommodate (at least in part) a diode device.

The wafer 1 includes a semiconductor substrate 2, typically of silicon, having an upper surface 2A and a lower surface 2B.

In particular, the semiconductor substrate 2 is a monocrystalline silicon substrate grown using a floating-zone technique with N-type doping having a resistivity designed according to a desired blocking voltage, maximum collector-emitter voltage V_{CE}.

By the term "substrate", the present description refers to any solid body that includes a base substrate only or a base substrate with one or more semiconductor layers subject to epitaxial growth thereon.

Using specific masks, a body region 11 with P-type conductivity has been implanted in the IGBT portion 1A and an anode region 13 of P-type has been implanted in the diode portion 1B. For example, a single body region 11 which occupies the entire area of the IGBT portion 1A and a single anode region 13 which occupies the entire area of the diode portion 1B may be implanted, the single body region 11 being subsequently separated into a plurality of body regions, as described hereinbelow.

In the IGBT portion 1A, within the single body region 11, a plurality of body contact regions 18, of P+ type, have already been selectively implanted and diffused, and source regions 20, of N+ type, have already been implanted and diffused, offset with respect to the body contact regions 18.

Furthermore, in both IGBT and diode portions 1A, 1B, trenches 24 have already been formed intended to accommodate, in the IGBT portion 1A, regions intended to form gate terminals (of the "trench-gate" type - and therefore hereinafter referred to as gate trench regions 25) and, in the diode portion 1B, regions intended to be electrically connected to an emitter terminal and therefore hereinafter referred to as emitter trench regions 26.

In the embodiment shown in Figure 1, the gate trench regions 25 and the emitter trench regions 26 are formed by three portions: an internal insulating portion 27A surrounded by a respective conductive layer 27B, surrounded in turn by a respective external dielectric layer 27C, as better visible in the enlarged detail of Figure 1B.

The three portions 27A-27C of the gate trench regions 25 and the emitter trench regions 26 are formed (simultaneously for the IGBT portion 1A and for the diode portion 1B) by subsequent deposition of the external dielectric layer 27C, of the conductive region 27B and of an insulating layer forming the internal insulating portion 27A and therefore hereinafter also referred to as internal insulating layer 27A.

As shown in the enlarged detail of Figure 1B, showing a cross-section through an emitter region 26 (but, at this stage, also valid for the gate trench regions 25 in the IGBT portion 1A), a portion of the external dielectric layer 27C may also extend above the upper surface 2A of the substrate 2 and a portion of the internal insulating layer 27A may also extend onto the upper surface 2A of the substrate 2, above the external dielectric layer 27C. Such portions of the external dielectric layer 27C and of the internal insulating layer 27A which extend above the upper surface 2A of the substrate 2 are hereinafter referred to as the surface insulating layer 28.

Figure 1B also shows the recessed shape of the internal insulating portion 27A and of the conductive layer 27B and the non-planar shape of the internal dielectric layer 27A above the trenches 24.

The insulating layer 28 may for example have a thickness within the range of micrometers (for example, 1-3 µm) on the upper surface 2A of the substrate 2.

The internal insulating portion 27A and the external dielectric layer 27C may be, for example, an oxide such as SiO₂ and the conductive region 27B may be, for example, doped polysilicon.

As better visible in Figure 1C, the gate trench regions 25 and the emitter trench regions 26 extend parallel to the second axis Y.

Furthermore, the gate trench regions 25 and the emitter trench regions 26 have, for example, a depth, measured along the third axis Z from the upper surface 2A, of the order of a few microns and a width, measured along the first axis X, of the order of tens of µm.

The distance (also known as pitch) between a trench 24 and the immediately subsequent (or preceding) trench 24 along the first axis X for both the IGBT portion 1A and the diode portion 1B is, for example, comprised within the range of a few µm.

In each trench 24, the external dielectric layer 27C completely covers the walls and the bottom of the respective trench 24, whereby the conductive layer 27B is electrically insulated from the substrate 2.

Conversely, the internal insulating portion 27A may not be completely surrounded by the conductive layer 27B, and be in contact with the external dielectric layer 27C on the bottom of the respective trench 24, as shown in Figure 1B. However, this is not essential.

In the IGBT portion 1A, the gate trench regions 25 extend through the previously formed single body region 11 and source regions 20, separating a plurality of body regions 14 and pairs of source regions 20 arranged on opposite sides of the trenches 24.

In the diode portion 1B, the emitter trench regions 26 extend through the anode region 13, which however remains electrically connected to the ends of the emitter trench regions 26, as is noted in Figure 1C showing the wafer 1 in top view.

In detail, in the embodiment shown in Figure 1C, the diode portion 1B has a square shape and the emitter trench regions 26 within the second diode portion 1B have a rectangular shape with main extension along the second axis Y. Furthermore, each emitter trench region 26 in the diode portion 1B is physically separated and electrically insulated both from the other emitter trench regions 26 in the diode portion 1B and from the gate trench regions 25 in the IGBT portion 1A.

The IGBT portion 1A surrounds the diode portion 1B on one or more sides (in this example, the IGBT portion 1A completely surrounds the diode portion 1B on all sides).

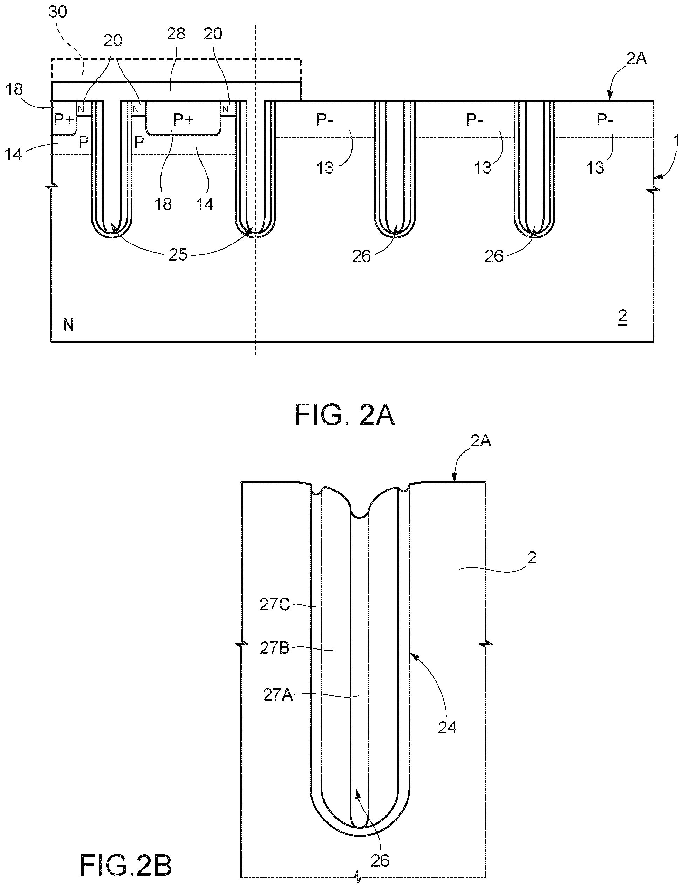

Afterwards, Figures 2A and 2B, the surface insulating layer 28 is selectively removed from the diode portion 1B, using a barrier mask 30, typically of photoresist, which covers the IGBT portion of the wafer 1.

As visible in Figure 2B, this removal leads to the recessed shape of the external dielectric layer 27C and of the internal insulating portion 27A at the emitter trench regions 26 (but not at the gate trench regions 25, protected by the barrier mask 30).

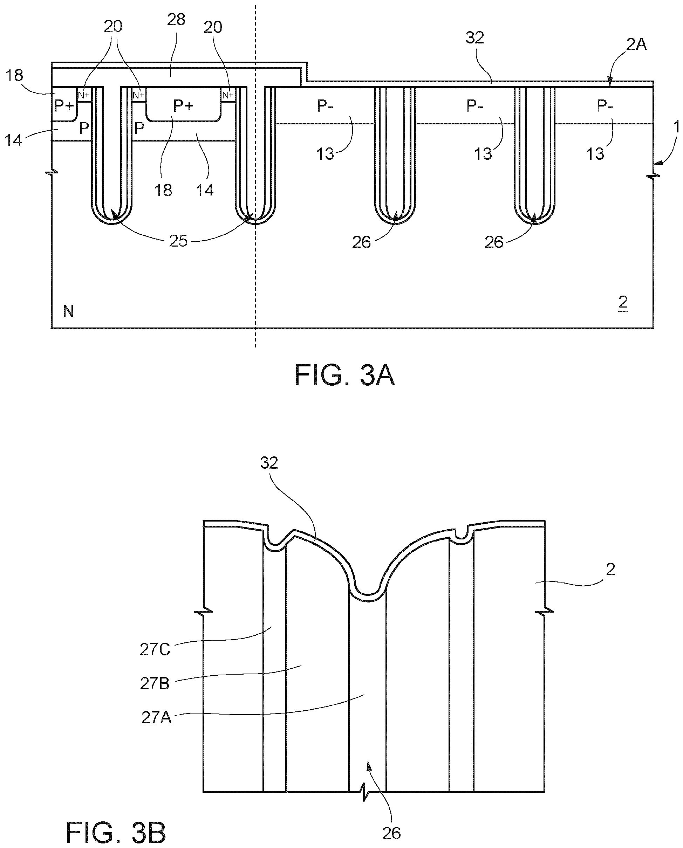

After removal of the barrier mask 30, a barrier metal layer 32 is deposited, Figures 3A and 3B.

The barrier metal layer 32 here covers the entire surface of the wafer 1, in direct physical contact with the substrate 2 in the diode portion 1B, and superimposed on the surface insulating layer 28 in the IGBT portion 1A.

The barrier metal layer 32 is here of cobalt, deposited for example to a thickness of 10-50 nm.

The wafer 1 is then subject to a first thermal process, for example an RTP (Rapid Thermal Processing) treatment at 400-500°C for 20-60 s, to allow the portion of the barrier metal layer 32 in the diode zone 1B to react with the silicon of the substrate 2 and possibly of the conductive layer 27B, forming, in the diode zone 1B, a CoSi2 layer, indicated by 32'.

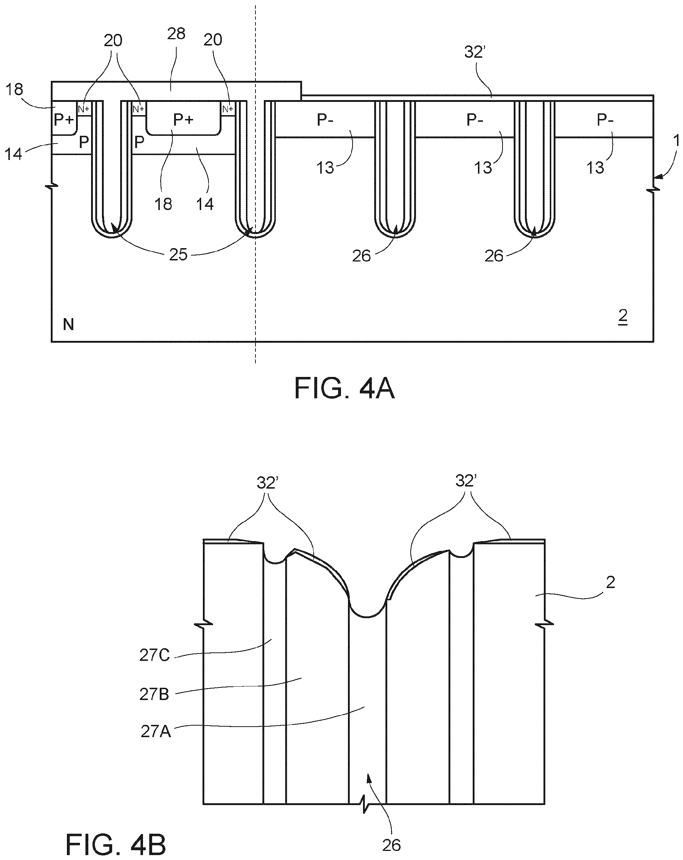

In particular, as is noted in Figure 4B, in the diode zone 1B, at the emitter trench regions 26, the CoSi₂ layer 32' forms barrier regions (also indicated by 32', of CoSi₂) over the conductive layer 27B, but not over the internal insulating portion 27A and the external dielectric layer 27C.

Conversely, in the IGBT zone 1A, the barrier metal layer 32 does not react and is removed by stripping, as shown in Figure 4B.

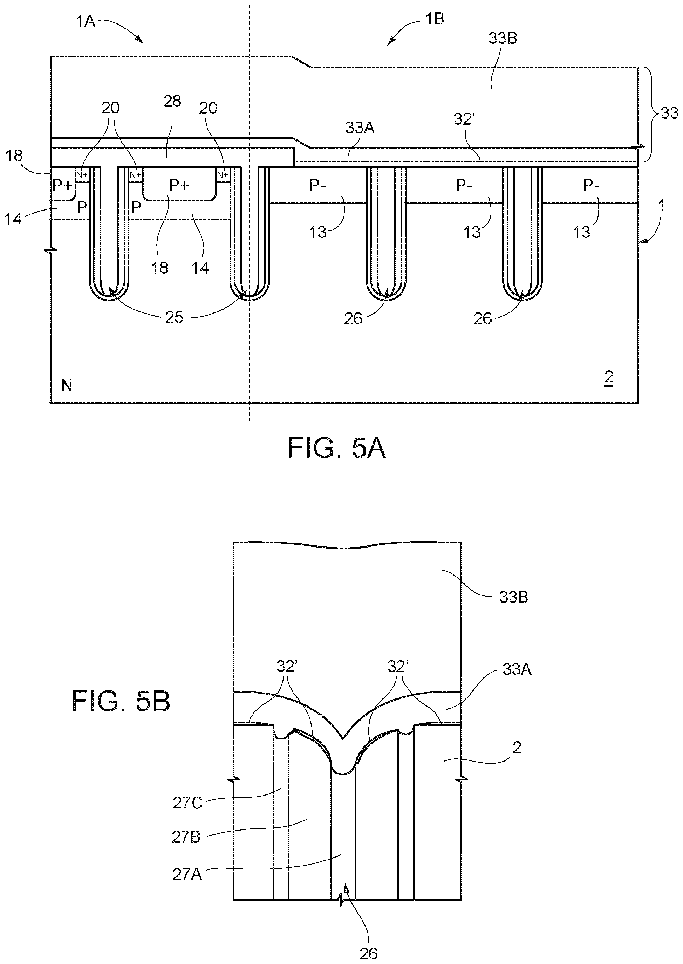

In Figures 5A and 5B, a PMD (Pre-Metal Dielectric) layer 33, for example of oxide such as silicon oxide, is deposited with a thickness in the range of micrometers (for example, 1-3 µm).

In particular, here, a double deposition step is performed, with initial deposition of an undoped PMD layer 33A and subsequent deposition of a doped PMD layer 33B.

For example, the undoped PMD layer 33A may have a thickness of about 200 nm and the doped PMD layer 33B may have a thickness of about 1000 nm.

Subsequently, the PMD layer 33 is subject to a rapid thermal processing (RTP) with temperatures comprised between 700 and 900°C for a time variable between 30 and 120 seconds, so as to reflow the PMD and at the same time convert the CoSi layer 32' into a CoSi₂ barrier layer, hereinafter referred to as barrier layer 32A.

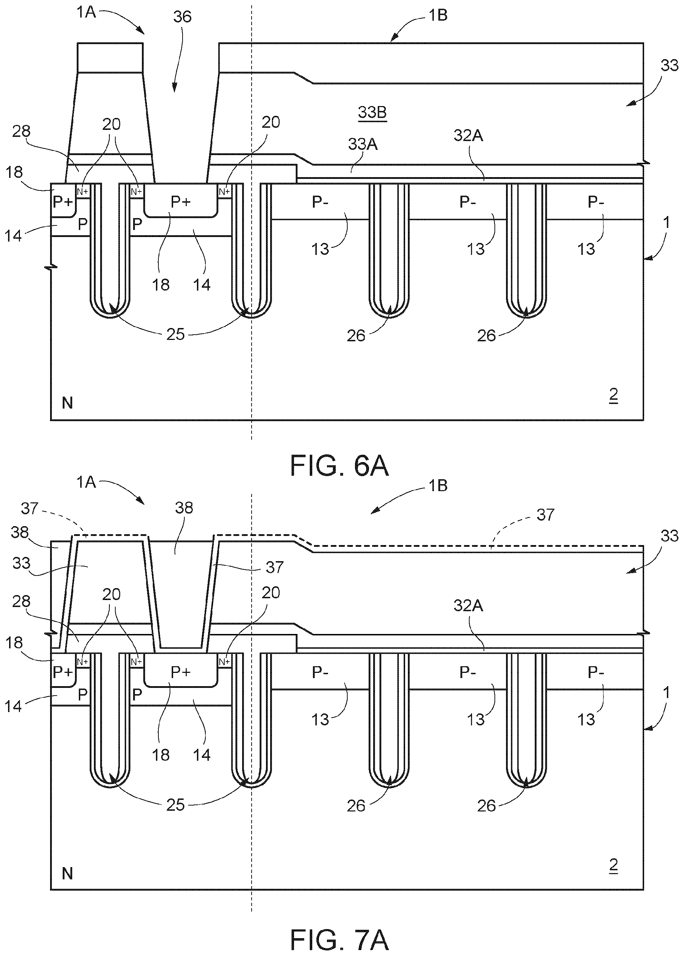

Afterwards, Figure 6A, a first contact mask 35, for example of photoresist, is formed on the PMD layer 33, to open, by a plasma etching step, a body contact opening 36 in the IGBT zone over the body regions 14 (in particular over the body contact regions 18).

Then, Figure 7A, the first contact mask 35 is removed, a contact barrier layer 37 is deposited; metal is grown, within the body contact opening 36, over the contact barrier layer 37, forming a body contact plug 38. Then the contact barrier layer 37 external to the body contact opening 36 is removed and remains only in contact with the walls of the body contact opening 36, surrounding the body contact plug 38 laterally and downwardly.

The contact barrier layer 37 may be formed by a double layer of Ti/TiN, obtained by sputtering, but other materials may be used, such as for example TiSi or TiW; the body contact plug 38 may be for example of tungsten (W), obtained by chemical vapor deposition or electrochemical deposition.

In general, the contact barrier layer 37 is configured to prevent the diffusion of Al and Cu within the substrate 2 and is also an adhesion layer.

Removal of the contact barrier layer 37 outside the body contact opening 36 may be obtained by plasma etch (with or without a dedicated mask) or by controlled acid wet etch.

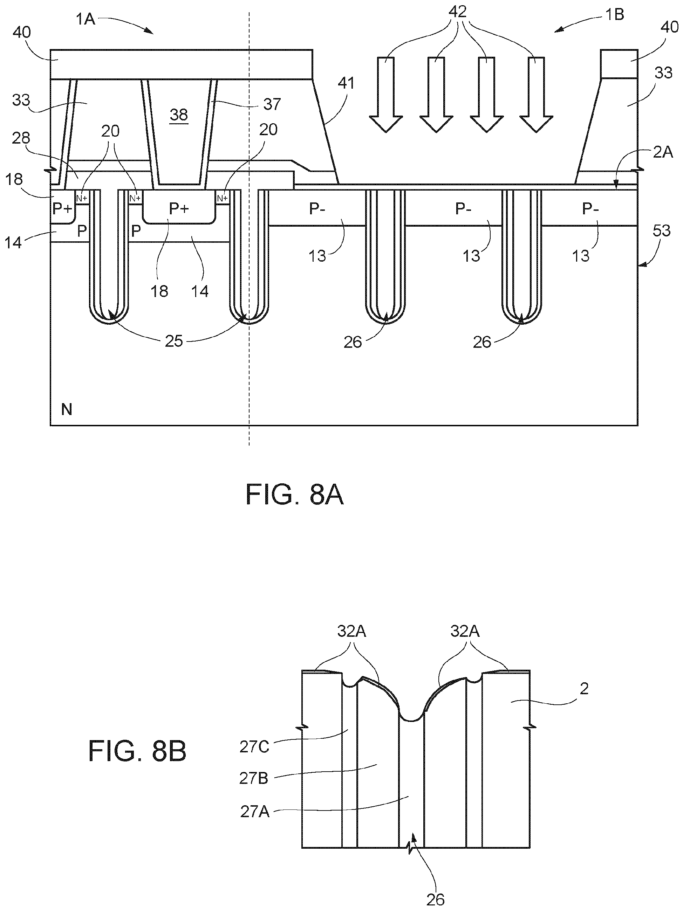

In Figures 8A, 8B, the PMD layer 33 is selectively removed from the diode portion 1B, to form an anode contact. In detail, a second contact mask 40, for example of photoresist, is formed on the PMD layer 33 to open a diode contact opening 41 in the diode portion 1B, for example by etch (in case of PMD layer 33 of silicon oxide, an HF-based etch).

The diode contact opening 41 here occupies essentially the entire area of the diode portion 1B and does not substantially modify the surface of the wafer 1 at the emitter trench regions 26, as visible from the comparison of Figures 8B and 4B.

Using the second contact mask 40, an optional contact enrichment step of the diode portion 1B is then performed, implanting P-type doping species into the anode regions 13 (as represented by the arrows 42). For example, BF₂ may be implanted with an energy of 15-50 keV and a dose of about 1.10¹² 1.10¹³ atoms/cm².

Furthermore, an annealing step follows.

The implant of Figure 8A allows the trade-off between VF (voltage drop on the diode in forward conduction mode) and Qrr (reverse recovery charge), i.e. between the ability of conducting current in the on-state and the turn-off speed, to be modulated.

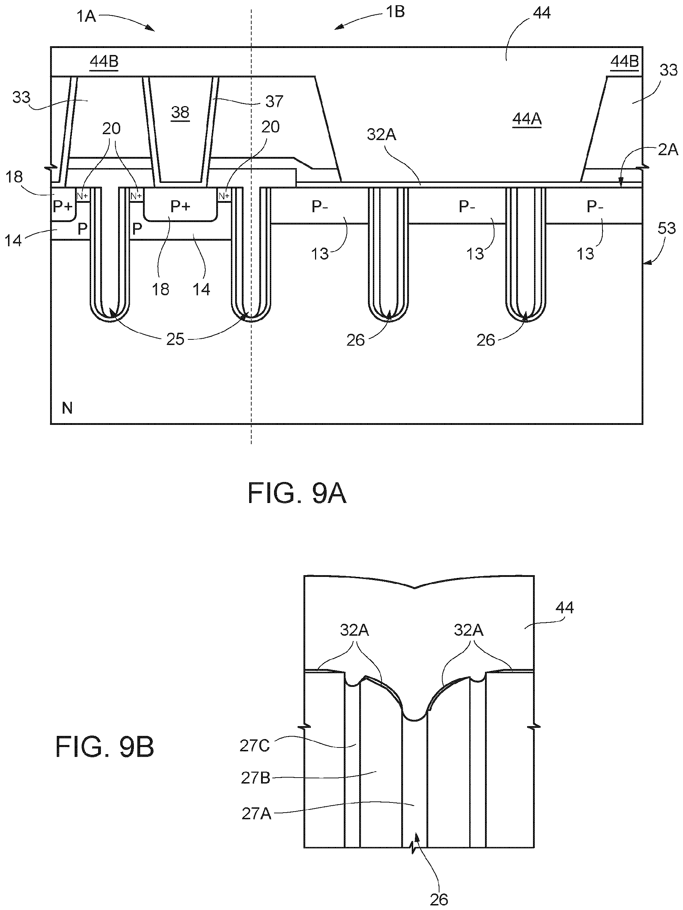

Then, Figures 9A and 9B, a front metal layer 44, in particular a silicon-free metal alloy, is formed on wafer 1.

In particular, the front metal layer 44 forms a diode contact plug portion 44A, arranged within the diode contact opening 41, in direct electrical contact with the barrier layer 32A, and a surface portion 44B, which extends both on the IGBT portion 1A and on the diode portion 1B and is here in direct electrical contact with the body contact plug 38.

The front metal layer 44 may be deposited by sputtering; the front metal layer 44 may be an Al-based material, for example an AlCu alloy or Al or any other alloy containing Si, such as AlSi or AlSiCu.

As shown in Figure 9B, the front metal layer 44 also covers the recessed upper surface of the emitter trench regions 26, in direct contact with the internal insulating portion 27A and the external dielectric layer 27C, and separated from the conductive layer 27B by the barrier layer 32A.

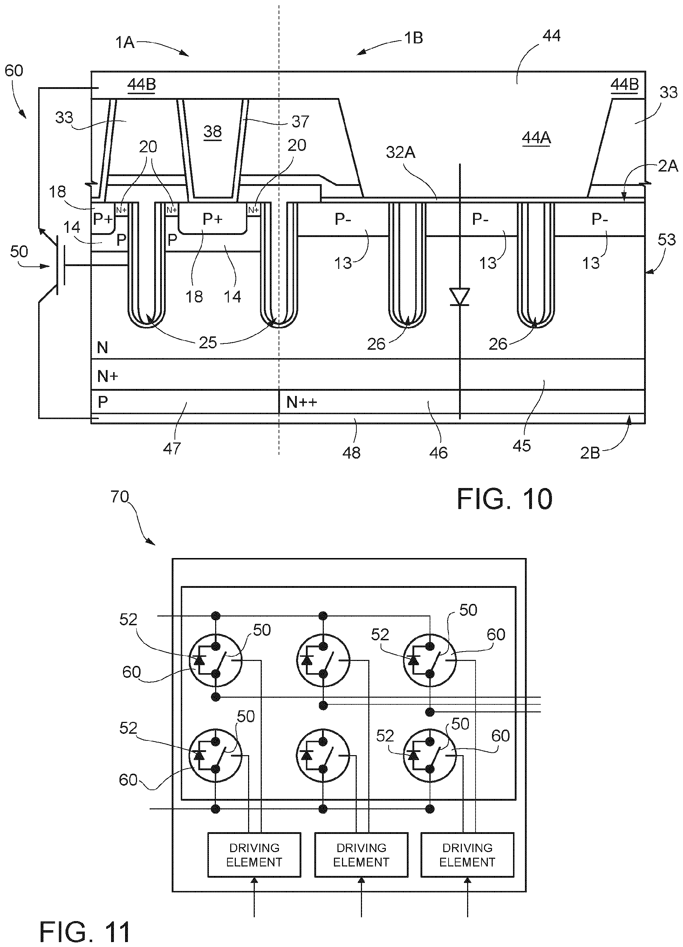

The manufacturing process comprises further Back-End-Of-Line (BEOL) steps, which lead to the structure shown in Figure 10, and including, in a per se known manner, back-thinning, for example through "grinding", up to reaching a desired final thickness (in Figure 10, the lower surface of the substrate 2 is again indicated by 2B, for consistency); forming a field stopper 45, of N-type, on the entire rear surface 2B of the substrate 2, for example by a masked implant; forming a cathode region 46, of N-type, on the field stopper 45 and more doped than the latter, only at the diode portion 1B; forming an emitter region 47, of P-type, on the field stopper 45, only at the IGBT portion 1A (in practice, arranged side by side to the cathode region 46; furthermore the order of these last two steps may be reversed); and forming a rear metal layer 48, for example of titanium/nickel/gold, titanium/nickel/silver, nickel/palladium, nickel/palladium/gold, by sputtering, in direct electrical contact both with the emitter region 47 and with the cathode region 46, which are thus short-circuited.

After dicing the wafer 2, a reverse-conducting IGBT device, RC-IGBT device 60, is obtained which includes an IGBT 50 and a diode 52 integrated in a same die 53 that is in the same substrate 2, as represented by the electrical symbols in Figure 10.

Many IGBT applications have an operating mode in which freewheeling current flows from the emitter to the collector. For this freewheeling operation, the diode 52, antiparallel-connected to the IGBT, operates as a freewheeling diode (FWD) .

Here, the emitter region 47 is the emitter of a PNP parasitic bipolar transistor present in the IGBT. The rear metal layer 48 forms both the anode of the diode 52 and the collector terminal of the IGBT 50; the latter has an emitter (or source) terminal formed by the front metal layer 44.

With reference to the RC-IGBT device 60 shown in Figure 10, the rear metal layer 48 (collector of the IGBT 50) electrically short-circuits the emitter region 47 of the parasitic bipolar transistor with the cathode region 46 of the diode 52, allowing the reverse conduction of the integrated diode 52. The electrical parameter that defines the forward voltage drop of the diode is VF_{EC} (Voltage Forward between Emitter and Collector terminals).

Figure 11 is a schematic representation of a system 70 comprising a plurality of RC-IGBT devices 60 integrated into a single die 53.

The described RC-IGBT device 60 has numerous advantages.

The barrier layer 32A, highly conductive, has a work function similar to silicon and avoids the formation of a Schottky contact between the front metal layer 44 and the anode region 13, allowing the correct operation of the diode 52. The low-injection diode structure is therefore particularly efficient.

Furthermore, the portion of the PMD layer 33 in contact with the barrier layer 32A (formed, as mentioned, by the undoped PMD layer 33A) contains few doping atoms with a low probability of diffusion within the substrate 2, through the barrier layer 32A; consequently, the PMD layer 33 does not modify the electrical characteristics and operativeness as a diode of the diode zone 1B.

In particular, the use of cobalt disilicide improves compatibility with the material of the front metal layer 44.

The described process has no constraints as to the aluminum-based material of the front metal layer 44.

Lifetime killing techniques are not necessary to prevent an increasing in leakages, especially at high temperatures.

The performances of the IGBT device are not negatively affected.

The process does not require steps that are expensive or low-compatible with semiconductor device manufacturing processes.

The described IGBT device 60 is therefore usable in a particularly favorable manner for hard-switching applications.

Finally, it is clear that modifications and variations may be made to the device and manufacturing process described and illustrated herein without thereby departing from the scope of the present invention, as defined in the attached claims.

For example, the gate trench regions 25 and the emitter trench regions 26 may comprise only two portions: an external insulating layer and an internal conductive layer.

Thinning the wafer is optional, based on the desired thickness dimensions. In particular, thinning the wafer depends on the final thickness required, which in turn depends on the design breakdown voltage and on the specification of the resistance of the device when the current flows in the on-state.

## Claims

1. A reverse-conducting IGBT, RC-IGBT, device (60), comprising:
a die (53) having a substrate (2) of a first conductivity type, the substrate having a first and a second main surface (2A, 2B);
an IGBT (50) in a first portion (1A) of the die;
a diode (52) in a second portion (1B) of the die,
the IGBT (50) comprising:
a body structure (14, 18) having a second conductivity type, the body structure being formed in the substrate (2), facing the first main surface (2A);
a source region (20), of the first conductivity type, the source region being formed in the substrate (2), facing the first main surface (2A) and adjacent to a surface portion of the body structure (14, 18),
a trench-gate region (25) extending into the substrate (2) from the first main surface (2A) towards the second main surface (2B), in a position adjacent to the source region and a deep portion of the body structure;
a first contact structure (37, 38), formed on the first main surface and in direct electrical contact with the body structure (14, 18);
an emitter region (47), of the second conductivity type, on the second upper surface (2B) of the substrate,
the diode (52) comprising:
an anode region (13), of the second conductivity type, the anode region being formed in the substrate (2), facing the first main surface (2A);
a second contact structure (32A, 44A), formed on the first main surface (2A) and in direct electrical contact with the anode region (13), the second contact structure being electrically coupled with the first contact structure (37, 38);
wherein the second contact structure (32A, 44A) comprises a barrier layer (32A) extending above the first main surface (2A) of the substrate, in contact with the anode region (13), and a diode contact plug (44A), of metal, above and in contact with the barrier layer (32A),
wherein the barrier layer (32A) is of cobalt disilicide.

2. The RC-IGBT device according to claim 1, wherein the first contact structure (37, 38) comprises a body contact plug (38), the RC-IGBT device comprising a front metal layer (44) comprising a surface portion (44B), extending on the IGBT portion (1A) and on the second portion (1B) and also forming the body contact plug (38) and the diode contact plug (44A).

3. The RC-IGBT device according to claim 1 or 2, wherein the diode contact plug (44A) is of an aluminum-based metal, chosen from the group comprising Al, AlCu, AlSi, and AlSiCu.

4. The RC-IGBT device according to any of the preceding claims, further comprising an emitter trench region (26) extending into the second portion (1B), from the first main surface (2A) towards the second main surface (2B) of the substrate (2).

5. The RC-IGBT device according to the preceding claim, wherein the emitter trench region (26) comprises an external dielectric layer (27C) and a conductive region (27B) surrounded by the external dielectric layer (27C), wherein the barrier layer (32A) extends in direct electrical contact with the conductive region (27B), but not with the external dielectric layer (27C).

6. The RC-IGBT device according to the preceding claim, wherein the emitter trench region (26) further comprises an internal insulating portion (27A), of dielectric material, surrounded by the conductive region (27B), the barrier layer (32A) not covering the internal insulating portion (27A).

7. An inverter stage (70), including a plurality of RC-IGBT devices (60) according to any of the preceding claims.

8. A process for manufacturing an RC-IGBT device, comprising:
in a wafer (1) of semiconductor material comprising a substrate (2) having a first and a second main surface (2A, 2B), forming an IGBT (50) in a first portion (1A) of the wafer and a diode (52) in a second portion (1B) of the wafer,
wherein forming an IGBT (50) includes:
- forming, in the first portion (1A) of the wafer (1), a body region (14) having a second conductivity type and facing the first main surface (2A),
- forming, in the body region (14), a source region (20) having the first conductivity type and facing the first main surface;
- forming a trench-gate region (25) extending into the substrate (2) from the first main surface (2A) towards the second main surface (2B), through the body region (14), adjacent to the source region (20); and
- forming a first contact structure (37, 38), on the first main surface and in direct electrical contact with the body region (14);
- forming an emitter region (47), of the second conductivity type, on the second main surface (2B),
wherein forming a diode (52) includes:
- forming, in the second portion (1B) of the wafer (1), an anode region (13) of the second conductivity type, facing the first main surface (1A); and
- forming, in the second portion (1B) of the wafer (1), a second contact structure (32A, 44A), above the first main surface and in direct electrical contact with the anode region (13), the second contact structure comprising a barrier layer (32A) of cobalt disilicide in direct contact with the anode region, and a diode contact plug (44A), of metal, above and in contact with the barrier layer (32A), the diode contact plug (44A) being electrically coupled with the first contact structure (37, 38).

9. The process according to the preceding claim, wherein forming the first and the second contact structures comprises:
forming, on the first main surface (2A), a dielectric layer (33);
opening a body contact opening (36) in the dielectric layer (33), in the first portion (1A) of the wafer;
filling the body contact opening (36) with metal material to form a body contact plug (38);
opening a diode contact opening (41) in the dielectric layer (33) in the second portion (1B) of the wafer;
forming a front metal layer (44) extending into the diode contact opening (41) and in direct electrical contact with the body contact plug, the front metal layer (44) forming, diode contact opening (41), a diode contact plug (44A) .

10. The process according to the preceding claim, wherein the front metal layer (44) is of an aluminum-based metal, chosen from the group comprising Al, AlCu, AlSi, and AlSiCu.

11. The process according to any of claims 8-10, further comprising, after opening a diode contact opening (41) and before forming a front metal layer (44), implanting (42) doping ion species of the second conductivity type in the second portion (1B) of the wafer (1).

12. The process according to any of claims 8-11, wherein forming a second contact structure (32A, 44A) comprises forming a surface insulating layer (28) on the first portion (1A) of the wafer (1); depositing a cobalt layer; reacting the cobalt layer with the semiconductor material, where exposed- to obtain the cobalt disilicide layer; and removing parts of the unreacted cobalt layer.

13. The process according to the preceding claim, further comprising:
before forming a second contact structure (32A, 44A), forming an emitter trench region (26) in the second portion of the wafer, the emitter trench region extending from the first main surface (2A) towards the second main surface (2B) of the wafer (1), through the anode region (13), wherein forming an emitter trench region (26) comprises selectively removing the semiconductor material of the substrate (2) to form a trench (24) having walls; depositing an external dielectric layer (27C) on the walls of the trench; forming a conductive region (27B) within the external dielectric layer (27C), wherein the barrier layer (32A) extends in direct electrical contact with the conductive region (27B), but not with the external dielectric layer (27C).
